# EUROPÄISCHE PATENTSCHRIFT

(11) **EP 1 696 528 B1**
(45) Veröffentlichungstag und Bekanntmachung des Hinweises auf die Patenterteilung: **05.11.2008**
(21) Anmeldenummer: 05003968.4
(22) Anmeldetag: 24.02.2005
(51) Int. Cl.: H01S 5/40, H01S 5/02

(54) **Halbleiterdiodenlaser und Verfahren zu seiner Herstellung**
Array of semiconductor lasers and its production method
Réseau de laser du type semi-conducteur et son procédé de production

(43) Veröffentlichungstag der Anmeldung: 30.08.2006
(73) Patentinhaber: TRUMPF Laser GmbH + Co. KG, 78713 Schramberg (DE)
(72) Erfinder: Huonker, Martin, 78658 Zimmern (DE)
(74) Vertreter: Rank, Christoph

(56) Entgegenhaltungen:
- US-A1- 2001 035 401
- US-A1- 2002 172 244
- US-A1- 2004 087 112

## Beschreibung

Die vorliegende Erfindung betrifft ein Verfahren zum Herstellen eines Halbleiterdiodenlasers gemäß dem Oberbegriff von Anspruch 1.

Ein solches Herstellungsverfahren ist beispielsweise durch die US-A-2002/0172244 bekannt geworden.

Ein wesentlich die Lebensdauer von Laserdioden bestimmender Faktor ist die Montage des Laserdiodenchips auf Wärmesenken. Insbesondere bei Laserbarren, d.h. bei ca. 10 mm breiten Streifen aus Halbleitermaterial, welche in mehrere Laserdiodenemitter unterteilt, aber körperlich nicht voneinander getrennt sind, gestaltet sich die Montage als schwierig, da die thermischen Ausdehnungskoeffizienten des Diodenmaterials und der üblicherweise aus Kupfer bestehenden Wärmesenke stark unterschiedlich sind und daher wegen der relativ großen Abmessungen der Laserbarren nach dem Abkühlen des gelöteten Verbundes zu starken internen Spannungen führen, welche die Lebensdauern nachteilig beeinflussen. Insbesondere auch im gepulsten oder leistungsmodulierten Betrieb wird die Lebensdauer solcherart gelöteter Laserbarren auf Grund der durch die leistungsabhängige Erwärmung verursachten ständigen thermomechanischen Lastwechsel reduziert. Demgegenüber liegen beispielsweise einzelne Laserdiodenemitter, die von den Abmessungen her wesentlich kleiner sind als Laserbarren, auf Grund der wesentlich geringeren thermomechanisch induzierten Spannungen von der Lebenserwartung fast eine Größenordnung höher, obwohl sie typischerweise bei wesentlich höheren Temperaturen gelötet werden.

Wegen des Problems der unterschiedlichen Ausdehnungskoeffizienten findet als Lot für die Montage von Laserbarren überwiegend Indium Verwendung, welches auch im festen Zustand noch so duktil ist, dass es die aus den unterschiedlichen Ausdehnungskoeffizienten beim Abkühlen des gelöteten Verbundes resultierenden Spannungen in begrenztem Umfang abzubauen vermag. Ein weiterer Vorteil von Indiumlot liegt in der vergleichsweise niedrigen Löttemperatur, welche das Maß der beim Abkühlen auftretenden Spannungen begrenzt. Die Lötung mit Indium erfordert allerdings eine sehr präzise definierte Temperaturführung des Lötprozesses und eine genau definierte Lotdicke. Darüber hinaus neigt das Indiumlot zur Elektromigration, d.h. zur Bildung von so genannten Whiskern (haarförmigen Strukturen), die seitlich aus der Lotschicht herauswachsen und die Facetten der Laserdioden kontaminieren können, was nicht selten zur Zerstörung der Facetten und damit zum vorzeitigen Lebensdauerende des betreffenden Diodenmoduls führt.

Ein weiteres Problem beim Löten von Laserbarren auf Wärmesenken besteht im Auftreten des sogenannten Smiles, d.h. einer Verbiegung der verlöteten Einheit, die durch Spannungen beim Abkühlen auf Grund der unterschiedlichen Wärmeausdehnungskoeffizienten von Laserbarren und Wärmesenke hervorgerufen wird.

Um diese Problematik zu vermeiden, kommen manchmal ausdehnungsangepasste Wärmesenken zum Einsatz, die mit anderen Lotsystemen (z.B. Gold/Zinn oder anderen Legierungen) gelötet werden können, welche bei höheren Temperaturen zu löten sind und die oben genannte Whiskerproblematik nicht aufweisen. In der Regel haben diese Lotwerkstoffe auch bessere Haftungseigenschaften als Indiumlot. Ausdehnungsangepasste Wärmesenken haben üblicherweise allerdings den Nachteil eines aufwändigeren Aufbaus und schlechterer thermischer Eigenschaften, die sich nachteilig auf die Betriebsparameter der Laserdiode(n) auswirken. In der Regel bestehen derartige Wärmesenken aus Werkstoffen, die sich mechanisch deutlich schlechter als Kupfer bearbeiten lassen.

Bei dem aus der US-A-2002/0172244 bekannten Herstellungsverfahren wird ein Laserdiodenlaser, nachdem er auf einen Träger aufgelötet ist, in einzelne Barrenabschnitte geteilt, die jeweils durch Fugen voneinander getrennt sind. Diese Fugen werden durch thermisches Spalten ("Thermal Cleaving") des Laserbarrens aufgrund der beim Abkühlen zwischen dem Laserbarren und dem Lot auftretenden Spannungen erzeugt, wobei die Spaltpositionen durch Schwächungsstrukturen im Laserbarren vorgegeben sind. Zusätzlich zu den Schwächungsstrukturen kann der Laserbarren mittels eines Lasers in die einzelnen Barrenabschnitte geschnitten werden.

Aus der DE 196 44 941 C1 ist es bekannt, in einem Laserbarren mithilfe eines Laserstrahls Sollbruchstellen einzubringen, bevor er mit Hartlot auf eine Wärmesenke mit geringerer Wärmeausdehnung als das Barrenmaterial aufgelötet wird. Wenn die Wärmesenke sich beim Abkühlen des Verbundes weniger zusammenzieht als der Laserbarren, entstehen beim schnellen Abkühlen Brüche im Laserbarren zwischen den einzelnen Dioden. Allerdings ist dieses Verfahren mit Kupfer-Wärmesenken nicht durchführbar, da Kupfer eine höhere thermische Ausdehnung aufweist als der Laserbarren und sich die Wärmesenke beim Abkühlen daher stärker als der Laserbarren zusammenzieht.

Aus der DE 198 21 544 A1 ist es weiterhin bekannt, den Träger des Laserbarrens in Stege zu unterteilen, so dass sich insgesamt eine angepasste thermische Ausdehnung von Laserbarren und Träger ergibt. Allerdings ist dieses Herstellungsverfahren kompliziert und aufwändig.

Aufgabe der vorliegenden Erfindung ist es daher, ein Herstellungsverfahren der eingangs genannten Art dahin gehend weiterzubilden, dass die Lebensdauer der Laserbarrenabschnitte weiter erhöht werden kann.

Diese Aufgabe wird erfindungsgemäß gelöst durch ein Herstellungsverfahren mit den Merkmalen von Anspruch 1.

Erfindungsgemäß erfolgt das Vereinzeln der Dioden bei Temperaturen, bis ca. 20 °C, vorzugsweise bis ca. 10 °C, unterhalb der Erstarrungstemperatur des Lots, so dass schon eine Haftung des präzise ausgerichteten Laserbarrens gegeben ist, aber noch keine merklichen abkühlungsbedingten Spannungen aufgebaut worden sind. Das Trennen eines Laserbarrens in kleinere Barrenabschnitte erfolgt bevorzugt mittels eines fokussierten Laserstrahls mit einer mittleren Leistung von einigen Watt und einem Fokusdurchmesser von einigen Mikrometern. Der Laserstrahl trägt mittels kurzen Pulsen Material zwischen den eigentlichen Laserdiodenemittern vollständig bis auf die Lötschicht ab, so dass die so entstehende Schnittfuge (Schnittspalt) quasi als Dehnfuge zwischen den einzelnen Barrenabschnitten wirkt. Insbesondere die Verwendung eines Lasers mit kurzen bzw. ultrakurzen Pulsen hat hierbei den Vorteil, dass das Diodenmaterial keine Schädigungen erleidet, die über die Abtragzone hinausgehen. Alternativ kann die Vereinzelung der Barrenabschnitte durch ein mechanisches Verfahren, durch Schneiden mit Wasserstrahl, Elektronen- oder Ionenstrahl oder durch Ätzen erfolgen.

Erfindungsgemäß werden die durch das Auflöten in den Laserbarren eingebrachten Spannungen durch in situ Vereinzelung des Laserbarrens in die einzelnen Barrenabschnitte verringert, und zwar entweder noch in der Abkühlphase des Lötprozesses, im vollständig erkalteten Zustand oder während eines dem Lötprozess nachfolgenden weiteren Erwärmungsprozesses. Die Erfindung gestattet es, Laserbarren mit höherschmelzendem, von der Whiskerproblematik nicht betroffenem Lot (z.B. Gold-Zinn-Hartlot) zu löten, ohne dass beim Abkühlen des gelöteten Verbundes Spannungen entstehen bzw. im Laserbarren verbleiben, welche die Lebenserwartung der solcherart gelöteten Laserbarren verringern oder zu einer Verbiegung des Verbundes führen. Ein weiterer Vorteil des Verfahrens liegt darin, dass beliebig lange Barren gelötet werden können.

Um ein Verschmutzen der Laserdiodenemitter während des Laserschneidens zu verhindern, können die beim Laserschneiden entstehenden Dämpfe aus dem Bereich der Schnittfuge mit einem inerten Schutzgas fortgeblasen oder abgesaugt werden.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: einen auf eine Wärmesenke aufgelöteten Laserbarren;
- Fig. 2: das Zerschneiden des aufgelöteten Laserbarrens mittels eines Laserstrahls; und
- Fig. 3: den erfindungsgemäß hergestellten Halbleiterdiodenlaser.

In den Figuren sind die einzelnen Verfahrensschritte zur erfindungsgemäßen Herstellung eines Halbleiterdiodenlasers gezeigt.

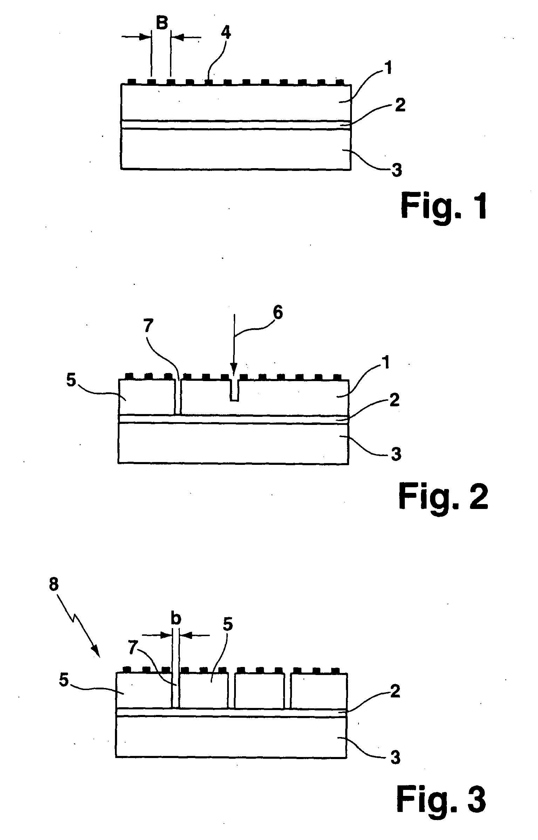

**Fig. 1** zeigt einen Laserbarren **1**, der mittels eines Hartlots **2** auf eine Wärmesenke **3** aufgelötet ist. Der Laserbarren **1** weist auf seiner Oberfläche eine Vielzahl von Diodenemittern **4** auf, die voneinander jeweils um ein Maß **B** beabstandet sind.

In der Abkühlphase des Lötprozesses, sobald das Hartlot 2 knapp unter seine Erstarrungstemperatur abgekühlt ist, wird der Laserbarren 1 in einzelne Barrenabschnitte **5** mittels eines fokussierten Laserstrahls **6** geschnitten (**Fig. 2**), dessen Fokusdurchmesser einige Mikrometer beträgt. Entsprechend hat die zwischen zwei Barrenabschnitten 5 vorhandene Schnittfuge **7** eine Breite **b** (b < B) von ebenfalls einigen Mikrometern (ca. 5 bis 10 µm). Die Erstarrungstemperatur des in diesem Zusammenhang als Hartlot wohl am meisten verwendeten Gold-Zinn-Eutektikums liegt bei ca. 280 °C, so dass das Laserschneiden idealerweise zwischen 280 °C und 270 °C erfolgt. Unterhalb der Erstarrungstemperatur ist in jedem Fall sichergestellt, dass das Hartlot 2 schon wieder fest ist, aber noch keine merklichen abkühlungsbedingten Spannungen aufgebaut worden sind und auch kein Verrutschen des präzise ausgerichteten Laserbarrens 1 auf der Wärmesenke 3 mehr möglich ist - auch unter Berücksichtigung etwaiger Ungenauigkeiten der Temperaturmessung. Beim Abkühlen bauen sich nur noch deutlich geringere Spannungen auf, wie sie auch beim Löten von einzelnen Laserdiodenemittern auftreten.

**Fig. 3** zeigt den so hergestellten Halbleiterdiodenlaser **8** mit mehreren parallelen Barrenabschnitten 5, die jeweils mehrere zu einer Gruppe zusammengefasste Laserdiodenemitter 4 aufweisen und durch Schnittfugen 7 vollständig voneinander getrennt sind.

## Patentansprüche

1. Verfahren zum Herstellen eines Halbleiterdiodenlasers (8) mit mehreren vollständig voneinander getrennten, jeweils einen einzelnen Laserdiodenemitter (4) oder mehrere zu einer Gruppe zusammengefasste Laserdiodenemitter (4) aufweisenden parallelen Barrenabschnitten (5), wobei ein Laserbarren (1) auf eine Wärmesenke (3) mittels eines Lots (2), vorzugsweise eines Hartlots, aufgelötet wird und die mehreren Barrenabschnitte (5) durch Einbringen jeweils einer Schnittfuge (7) in den aufgelöteten Laserbarren (1) ausgebildet werden,
**dadurch gekennzeichnet,**
**dass** das Einbringen der Schnittfuge bzw. -fugen (7) bei Temperaturen bis ca. 20 °C, vorzugsweise bis ca. 10°C, unterhalb der Erstarrungstemperatur des Lots (2) erfolgt.

2. Verfahren nach Anspruch 1, **dadurch gekennzeichnet, dass** das Einbringen der Schnittfuge bzw. -fugen (7) in der Abkühlphase des Lötprozesses erfolgt.

3. Verfahren nach Anspruch 1, **dadurch gekennzeichnet, dass** das Einbringen der Schnittfuge bzw. -fugen (7) während eines dem Lötprozess nachfolgenden weiteren Erwärmungsprozess erfolgt.

4. Verfahren nach einem der Ansprüche 1 bis 3, **dadurch gekennzeichnet, dass** das Einbringen der Schnittfuge bzw. -fugen (7) mittels eines insbesondere gepulsten Laserstrahls (6) erfolgt.

5. Verfahren nach Anspruch 4, **dadurch gekennzeichnet, dass** der Laserstrahl (6) auf die der Wärmesenke (3) gegenüberliegende Oberfläche des Laserbarrens (1) gerichtet wird.

6. Verfahren nach einem der Ansprüche 1 bis 5, **dadurch gekennzeichnet, dass** das Einbringen der Schnittfuge bzw. -fugen (7) im Vakuum oder in einer Schutzgasatmosphäre erfolgt.

7. Verfahren nach einem der Ansprüche 1 bis 6, **dadurch gekennzeichnet, dass** die beim Einbringen der Schnittfuge bzw. -fugen (7) entstehenden Dämpfe aus dem Bereich der Schnittfuge (7) mit Schutzgas fortgeblasen oder mittels Unterdruck abgesaugt werden.

## Claims

1. A method of fabricating a semiconductor laser diode (8) having plural parallel bar sections (5) completely separated from each other, comprising an individual laser diode emitter (4) each or plural laser diode emitters (4) combined in a group, with one laser bar (1) being soldered to a heat sink (3) by means of a solder (2), preferably a hard solder, and the plurality of bar sections (5) being formed by cutting a kerf (7) each into the soldered laser bar (1),
**characterized in that**
the cutting of the kerf and/or kerf(s) (7) is made at temperatures up to approximately 20°C, preferably up to approximately 10°C, below the solidification temperature of the solder (2).

2. The method to claim 1, **characterized in that** the cutting of the kerf and/or kerfs (7) is made during the cooling period of the soldering process.

3. The method to claim 1, **characterized in that** the cutting of the kerf and/or kerfs (7) is made during a further heating process subsequent to the soldering process.

4. The method to any one of claims 1 to 3, **characterized in that** the cutting of the kerf and/or kerfs (7) is made by means of a laser beam (6), in particular a pulsed laser beam.

5. The method to claim 4, **characterized in that** the laser beam (6) is directed to the surface of the laser bar (1) opposite of the heat sink (3).

6. The method to any one of claims 1 to 5, **characterized in that** the cutting of the kerf and/or kerfs (7) is made under vacuum or under protective gas atmosphere.

7. The method of any one of claims 1 to 6, **characterized in that** the vapours produced upon the cutting of the kerf and/or kerfs (7) are blown away from the region of the kerf (7) using protective gas or suctioned away by means of underpressure.

## Revendications

1. Procédé de fabrication d'un laser à diodes semi-conductrices (8) comprenant plusieurs sections de barre (5) parallèles présentent chacune un seul émetteur à diode laser (4) ou plusieurs émetteurs à diode laser (4) réunis en un groupe, une barre laser (1) étant brasée sur un dissipateur thermique (3) au moyen d'un métal d'apport de brasage (2), de préférence d'un métal d'apport de brasage fort, et les plusieurs sections de barre (5) étant formées chaque fois en réalisant un trait de coupe (7) dans les barres laser (1) brasées,
**caractérisé en ce**
**que** le trait ou les traits de coupe (7) sont réalisés à des températures jusqu'à environ 20 °C, de préférence jusqu'à environ 10°C, au-dessous de la température de solidification du métal d'apport de brasage (2).

2. Procédé selon la revendication 1, **caractérisé en ce que** le trait ou les traits de coupe (7) est ou sont réalisé(s) dans la phase de refroidissement du processus de brasage.

3. Procédé selon la revendication 1, **caractérisé en ce que** le trait ou les traits de coupe (7) est ou sont réalisé(s) pendant un processus d'échauffement supplémentaire consécutif au processus de brasage.

4. Procédé selon l'une des revendications 1 à 3, **caractérisé en ce que** le trait ou les traits de coupe (7) est ou sont réalisé(s) au moyen d'un faisceau laser (6) en particulier pulsé.

5. Procédé selon la revendication 4, **caractérisé en ce que** le faisceau laser (6) est dirigé sur la surface de la barre laser (1) opposée au dissipateur thermique (3).

6. Procédé selon l'une des revendications 1 à 5, **caractérisé en ce que** le trait ou les traits de coupe (7) est ou sont réalisé(s) dans le vide ou dans une atmosphère de gaz inerte.

7. Procédé selon l'une des revendications 1 à 6, **caractérisé en ce que** les vapeurs formées lors de la réalisation du trait ou des traits de coupe (7) sont évacuées de la zone du trait de coupe (7) par soufflage de gaz inerte ou aspiration au moyen d'une dépression.
